(19) Europäisches Patentamt
European Patent Office
Office européen des brevets

(11) **EP 1 821 339 B1**

(12) **EUROPEAN PATENT SPECIFICATION**

(45) Date of publication and mention
of the grant of the patent:
**12.10.2016 Bulletin 2016/41**

(51) Int Cl.:
*G01B 11/30* *(2006.01)*     *H01L 21/02* *(2006.01)*
*H01L 21/306* *(2006.01)*     *C30B 25/20* *(2006.01)*
*C30B 29/40* *(2006.01)*     *H01L 33/00* *(2010.01)*

(21) Application number: **07000261.3**

(22) Date of filing: **08.01.2007**

(54) **GaN crystal substrate and method of manufacturing the same, and method of manufacturing semiconductor device**

GaN-Kristallsubstrat und Verfahren zu dessen Herstellung sowie Verfahren zur Herstellung eines Halbleiterbauelements

Substrat cristallin de GaN, son procédé de fabrication et procédé de fabrication d'un dispositif semi-conducteur

(84) Designated Contracting States:
**DE FR GB**

(30) Priority: **15.02.2006 JP 2006038648**

(43) Date of publication of application:
**22.08.2007 Bulletin 2007/34**

(73) Proprietor: **Sumitomo Electric Industries, Ltd.**
**Osaka-shi, Osaka 541-0041 (JP)**

(72) Inventor: **Tanaka, Noriko**
**1-chome**
**Itami-shi**
**Hyogo 664-0016 (JP)**

(74) Representative: **Grünecker Patent- und**
**Rechtsanwälte**
**PartG mbB**
**Leopoldstraße 4**
**80802 München (DE)**

(56) References cited:
**EP-A- 0 966 047**     **EP-A- 1 246 233**
**EP-A2- 1 475 826**     **WO-A-01/68955**
**US-A1- 2003 045 103**

- **ANONYMOUS: 'Aerospace Engineering Guide Surface Finish (Measurement Methods) R a -Arithmetic Average Roughness', [Online] 01 April 2008, XP055166022 Retrieved from the Internet: <URL:http://www.alphaomegapt.com/pdf files/Surface Finish Definitions.pdf> [retrieved on 2015-01-29]**

**Description**

BACKGROUND OF THE INVENTION

Field of the Invention

The present invention relates to a GaN crystal substrate used in a semiconductor device such as a light emitting element, an electronic element, or a semiconductor sensor, a method of manufacturing the same, and a method of manufacturing a semiconductor device for which the GaN crystal substrate is selected as a substrate.

Description of the Background Art

A GaN crystal substrate is very useful as a substrate for a semiconductor device such as a light emitting element, an electronic element, or a semiconductor sensor. Such a GaN crystal substrate is formed by cutting a GaN crystal grown by vapor phase epitaxy such as HVPE (hydride vapor phase epitaxy) or MOVPE (metalorganic vapor phase epitaxy) into substrates of a predetermined shape, and grinding, lapping, and/or etching a main surface thereof.

In order to obtain a semiconductor device having excellent properties by forming at least one semiconductor layer having good crystallinity (meaning orderliness of atomic arrangement in a crystal; hereinafter the same applies) on a crystal growth surface, which is one main surface, of a GaN crystal substrate, there has been proposed a GaN crystal substrate having reduced warpage and surface roughness on a crystal growth surface (see for example Japanese Patent Laying-Open No. 2000-012900 (Patent Document 1)).

Even when the crystal growth surface of a GaN crystal substrate has reduced warpage and surface roughness, however, if a rear surface (meaning the other main surface, that is, a surface opposite to the crystal growth surface; hereinafter the same applies) of the GaN crystal substrate has a large warpage, this causes an increase in a gap portion formed between the rear surface of the substrate and a susceptor (meaning a table on which a substrate is disposed; hereinafter the same applies) when a semiconductor layer is formed on the crystal growth surface of the substrate. As a result, heat transferred from the susceptor to the substrate is unevenly distributed, and the semiconductor layer cannot be formed evenly and stably on the crystal growth surface of the substrate. Consequently, there has been a problem that a semiconductor layer having good crystallinity cannot be formed on the crystal growth surface of the substrate, and thus a semiconductor device having excellent properties cannot be obtained. Further, although the rear surface of a GaN crystal substrate generally has a surface roughness greater than a surface roughness of the crystal growth surface, the same problem as described above has occurred when the rear surface has an extremely greater surface roughness.

WO 01/68955 A1 describes III-V nitride substrate boule and method of making and using the same. A boule formed by high rate vapor phase growth of Group III-V nitride boules (ingots) on native nitride seeds, from which wafers may be derived for fabrication of microelectronic structures. The boule is of microelectronic device quality, e.g., having a transverse dimension greater than 1 centimeter, a length greater than 1 millimeter, and a top surface defect density of less than $10^7$ defects $cm^2$. The Group III-V nitride boule may be formed by growing a Group III-V nitride material on a corresponding native Group III-V nitride seed crystal by vapor phase epitaxy at a growth rate above 20 micrometers per hour.

EP 1 246 233 A2 describes semiconductor substrate made of group III nitride, and process for manufacture thereof.

US 2003/0045103 A1 describes nitride III-V compound semiconductor substrate, its manufacturing method, manufacturing method of a semiconductor light emitting device, and manufacturing method of a semiconductor device.

EP 0 966 047 A2 describes GaN single crystal substrate and method of producing same.

EP 1475826 A2 shows a GaN wafer having reduced warpage with a radius of larger than 26 m and mirror polished surfaces at the growth surface and the bottom surface in order to reduce particle contamination.

SUMMARY OF THE INVENTION

It is the object of the present invention to improve GaN crystal substrate. This object is achieved by providing a GaN crystal substrate according to claim 1 and a method of manufacturing a GaN crystal substrate according to claim 4. Embodiments of the invention are set forth in the dependent claims.

BRIEF DESCRIPTION OF THE DRAWINGS

Figs. 1A and 1B are schematic cross sectional views showing warpage of a rear surface of a GaN crystal substrate in accordance with the present invention.

Fig. 2 is a flow chart illustrating a method of measuring the warpage of the rear surface of the GaN crystal substrate in accordance with the present invention.

Fig. 3 is a schematic view of a measuring apparatus used in the method of measuring the warpage of the rear surface of the GaN crystal substrate in accordance with the present invention.

Fig. 4 is a schematic plan view showing a plurality of measurement points in the method of measuring the warpage of the rear surface of the GaN crystal substrate in accordance with the present invention.

Fig. 5 is a schematic view showing an arrangement of the plurality of measurement points.

Fig. 6A is a schematic view of a kernel for an 8-neighborhood Gaussian filter illustrating positions at which Gaussian functions f(x, y) serving as coefficients are arranged.

Fig. 6B is a schematic view of a kernel for an 8-neighborhood Gaussian filter illustrating an arrangement of coefficients with $\sigma=5$ before normalization.

Fig. 6C is a schematic view of a kernel for an 8-neighborhood Gaussian filter illustrating an arrangement of coefficients with $\sigma=5$ after normalization.

Figs. 7A and 7B are schematic views showing a warpage calculation step in the method of measuring the warpage of the rear surface of the GaN crystal substrate in accordance with the present invention.

Fig. 8 is a schematic cross sectional view showing a method of manufacturing the GaN crystal substrate in accordance with the present invention.

Fig. 9 is a schematic cross sectional view showing a method of manufacturing a semiconductor device in accordance with the present invention.

Fig. 10 is a view showing relation between the warpage of the rear surface of the GaN crystal substrate and a yield of the semiconductor device.

## DESCRIPTION OF THE PREFERRED EMBODIMENTS

### First Embodiment

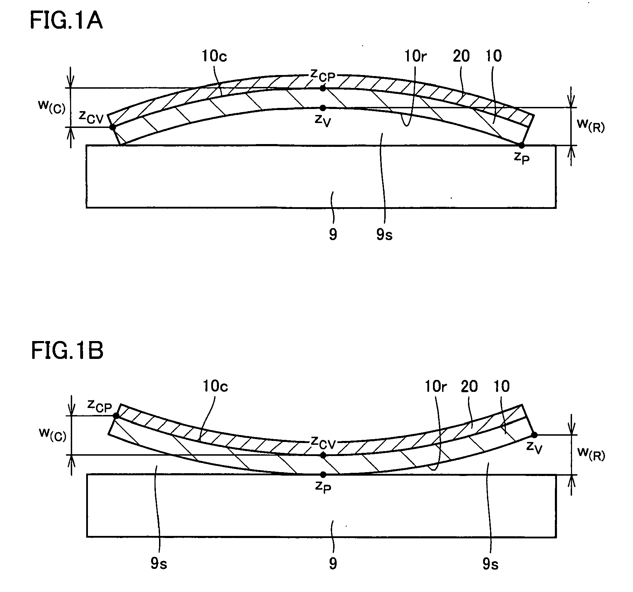

Referring to Figs. 1A and 1B, in an embodiment of a GaN crystal substrate not in accordance with the present invention, a rear surface 10r opposite to a crystal growth surface 10c has a warpage $w_{(R)}$ satisfying $-50 \mu m \leq w_{(R)} \leq 50 \mu m$, where a warpage causing rear surface 10r to be concavely curved as shown in Fig. 1A is indicated with a positive (+) sign, and a warpage causing rear surface 10r to be convexly curved as shown in Fig. 1B is indicated with a negative (-) sign. Warpage $w_{(R)}$ is defined as a difference in height between a displacement value $z_P$ at the most convex portion and a displacement value $z_V$ at the most concave portion of rear surface 10r.

Referring to Figs. 1A and 1B, if warpage $w_{(R)}$ of rear surface 10r satisfies $w_{(R)} < -50 \mu m$ or $w_{(R)} > 50 \mu m$, a gap portion 9s formed between a GaN crystal substrate 10 and a susceptor 9 is increased. This results in uneven distribution of heat transferred from susceptor 9 to GaN crystal substrate 10 when at least one group-III nitride crystal layer 20 is grown as a semiconductor layer on crystal growth surface 10c of GaN crystal substrate 10. As a result, semiconductor layer 20 cannot be grown evenly and stably, which makes it difficult to manufacture a semiconductor device formed evenly and having excellent properties.

In view of the above, the rear surface 10r in accordance with the present invention has warpage $w_{(R)}$ satisfying $-35 \mu m \leq w_{(R)} \leq 45 \mu m$. When the warpage of rear surface 10r is indicated with a positive (+) sign, gap portion 9s formed between rear surface 10r and a surface of susceptor 9 is a closed space as shown in Fig. 1A. On the other hand, when the warpage of rear surface 10r is indicated with a negative (-) sign, gap portion 9s formed between rear surface 10r and the surface of susceptor 9 is an open space as shown in Fig. 1B. Therefore, when semiconductor layer 20 is formed on crystal growth surface 10c of substrate 10, heat distribution in the substrate when the warpage is indicated with a positive (+) sign is smaller than heat distribution in the substrate when the warpage indicated with a negative (-) sign. It is contemplated that a preferable range of the warpage is larger on a positive (+) side than on a negative (-) side.

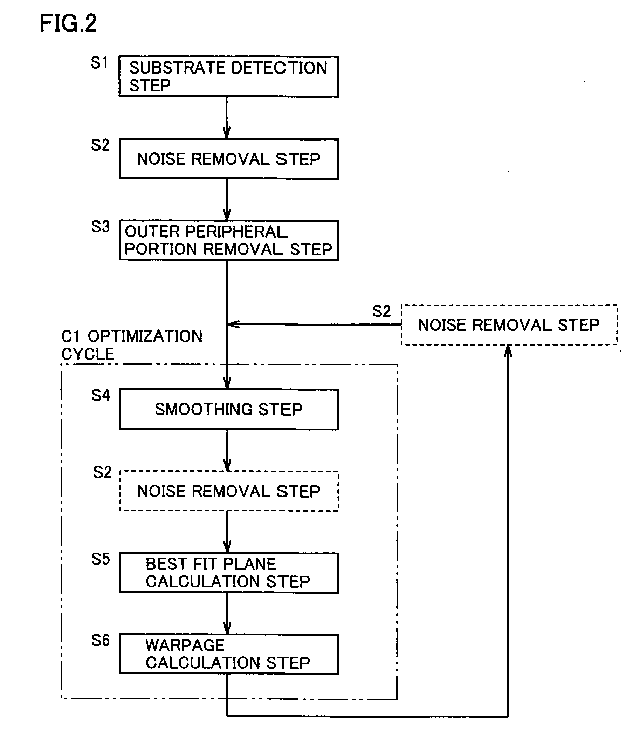

Since rear surface 10r of the substrate (GaN crystal substrate 10) generally has a high surface roughness, the warpage of rear surface 10r of the substrate (GaN crystal substrate 10) was measured by a method for accurately measuring the warpage of rear surface 10r described below. Referring to Fig. 2, the measurement method is a method of measuring warpage of a rear surface opposite to a crystal growth surface of a substrate using a laser displacement meter, and the substrate is disposed on a substrate support table. The method includes: a substrate detection step S1 detecting a plurality of displacement values respectively corresponding to a plurality of measurement points on the rear surface of the substrate using the laser displacement meter; a noise removal step S2 removing noise contained in the plurality of displacement values; an outer peripheral portion removal step S3 calculating a plurality of displacement values for calculation by removing from the plurality of displacement values those respectively corresponding to the measurement points in an outer peripheral portion of the substrate; a smoothing step S4 smoothing the plurality of displacement values for calculation to calculate a warped surface; a best fit plane calculation step S5 calculating a best fit plane having the minimum distance to the warped surface; and a warpage calculation step S6 calculating as warpage a sum of a distance from the best fit plane to a point represented by the greatest displacement value of the warped surface on one side with respect to the best fit plane and a distance from the best fit plane to a point represented by the greatest displacement value of the warped surface on the other side with respect to the best fit plane. With the measurement method described above, even for a substrate having a rear surface with a high surface roughness (for example, with a surface roughness Ra of not less than 50 nm), the warpage of the rear surface of the substrate can be measured. It is to be noted that surface roughness Ra is a value obtained by sampling a portion having a reference length from a roughness curve in a direction of its mean line, summing up absolute values of deviations from a mean line of the sampled portion to a measurement curve, and calculating an average for the reference length. Further, in Fig. 2, the step surrounded with a solid frame is an indispensable step, and the step surrounded with a dashed frame is an arbitrary step.

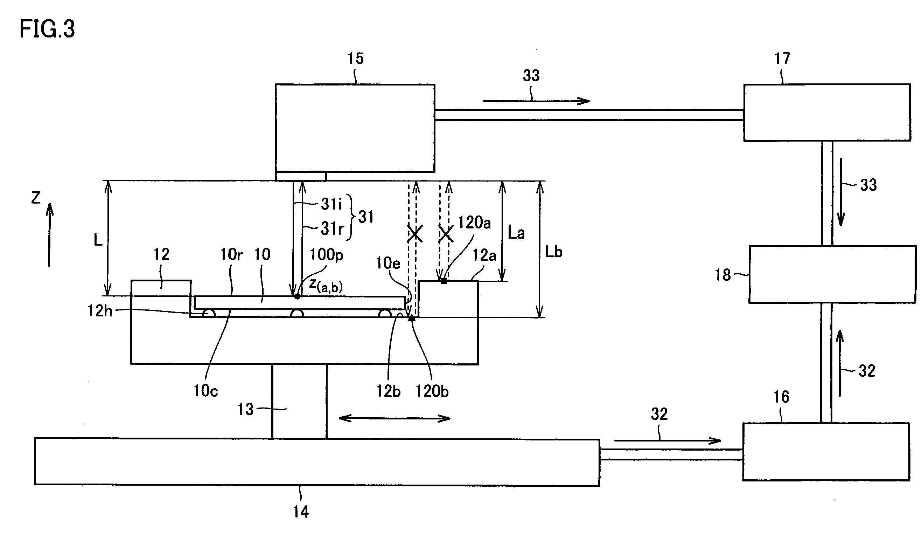

Turning to Fig. 3, a laser displacement meter 15 is an apparatus measuring a displacement of rear surface 10r of the substrate (GaN crystal substrate 10) by applying a laser beam 31 on rear surface 10r of the substrate (GaN crystal substrate 10). There is no particular limitation on the type of the laser, and for example a red color semiconductor laser having a wavelength of 670 nm is used. There is no particular limitation on the measuring technique, and for example a laser focus technique is used. Although a laser displacement meter employing the laser focus technique has a lower accuracy than a flatness tester employing optical interferometry, it can measure a rough rear surface with surface roughness Ra of not less than 50 nm. Further, unlike the flatness tester employing optical interferometry, the laser displacement meter employing the laser focus technique can obtain a reflected beam 31r, and thus it can analyze and process a displacement value.

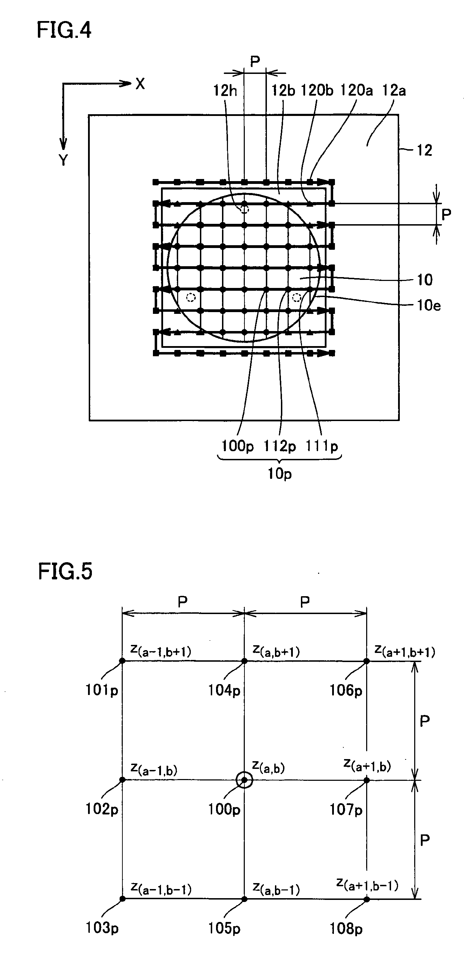

Referring to Figs. 3 and 4, the substrate (GaN crystal substrate 10) is disposed on a substrate support table 12. Although there is no particular limitation on how to dispose the substrate (GaN crystal substrate 10) on substrate support table 12, the substrate (GaN crystal substrate 10) is preferably disposed on substrate support table 12 having three supporting portions 12h such that crystal growth surface 10c of the substrate (GaN crystal substrate 10) is supported by the three supporting portions 12h. Supporting an outer peripheral portion of crystal growth surface 10c of the substrate (GaN crystal substrate 10) only by the three supporting portions 12h can minimize damage to crystal growth surface 10c during the measurement of warpage. Further, even when the substrate (GaN crystal substrate 10) is inclined while being supported by the above three portions, the inclination of the substrate (GaN crystal substrate 10) can be compensated for by calculating a best fit plane having the minimum distance to a warped surface (meaning a curved surface indicating warpage of a rear surface; hereinafter the same applies), and calculating a distance from the best fit plane to the warped surface.

Referring to Figs. 2 to 4, although there is no particular limitation on the substrate detection step S1, the step can be performed by measuring a distance L between laser displacement meter 15 and rear surface 10r of the substrate (GaN crystal substrate 10) while moving the substrate (GaN crystal substrate 10) in a two-dimensional direction (meaning an X direction and a Y direction in Fig. 4; hereinafter the same applies) in a stepwise fashion. The stepwise movement of the substrate (GaN crystal substrate 10) in the two-dimensional direction can be performed by moving a driving portion 13 coupling substrate support table 12 to a driving unit 14 in the two-dimensional direction in a stepwise fashion. Driving unit 14 is controlled by a position controlling unit 16.

On this occasion, position data in the two-dimensional direction of a measurement point 100p (an arbitrarily specified measurement point) irradiated with laser beam 31 among the plurality of measurement points on the rear surface of the substrate is collected to a data analysis unit 18 via position controlling unit 16. Here, an arrow 32 in Fig. 3 indicates a direction in which the position data is transmitted.

While there is no particular limitation on how to measure distance L, it can for example be measured by the laser focus technique. The laser focus technique will now be described below. An incident beam 31i emitted from a light source in laser displacement meter 15 is applied to arbitrarily specified measurement point 100p on rear surface 10r of the substrate (GaN crystal substrate 10) via an objective lens (not shown) moved up and down at a high speed within laser displacement meter 15 by means of a tuning fork. Reflected beam 31r from arbitrarily specified measurement point 100p passes through a pin hole (not shown) in laser displacement meter 15 and reaches a light receiving element (not shown). According to the confocal principle, when incident beam 31i is focused on arbitrarily specified measurement point 100p on rear surface 10r of the substrate (GaN crystal substrate 10), reflected beam 31r is focused into one point at a position of the pin hole and enters the light receiving element. By measuring a position of the turning fork on this occasion with a sensor (not shown), distance L between laser displacement meter 15 and arbitrarily specified measurement point 100p on rear surface 10r of the substrate (GaN crystal substrate 10) can be measured. With this manner, a displacement value $z_{(a, b)}$ (meaning a displacement value in a Z direction; hereinafter the same applies) of arbitrarily specified measurement point 100p on rear surface 10r of the substrate (GaN crystal substrate 10) can be measured.

On this occasion, displacement value data of arbitrarily specified measurement point 100p among a plurality of measurement points 10p on rear surface 10r of the substrate (GaN crystal substrate 10) is collected to data analysis unit 18 via a laser displacement meter controlling unit 17. Here, an arrow 33 in Fig. 3 indicates a direction in which the displacement value data is transmitted.

Next, the above measurement is performed after the substrate is moved in a stepwise fashion (for example in the X direction or the Y direction at a constant pitch P) as shown in Figs. 3 and 4, and thus the position data in the two-dimensional direction (the X direction and the Y direction) and the displacement value data in the Z direction of a measurement point adjacent to arbitrarily specified measurement point 100p at pitch P can be obtained. Through repeating the above operation, the position data in the two-dimensional direction (the X direction and the Y direction) and the displacement value data in the Z direction of each of the plurality of measurement points 10p on rear surface 10r of the substrate (GaN crystal substrate 10) can be obtained. The position data in the two-dimensional direction (the X direction and the Y direction) and the displacement value data in the Z direction obtained as described above are collected to data analysis unit 18.

As shown in Fig. 4, when the substrate (GaN crystal substrate 10) of a circular shape is moved in a stepwise fashion at constant pitch P in the two-dimensional direction, there may be a case where the laser beam is applied to substrate support table 12 instead of rear surface 10r of the substrate (GaN crystal substrate 10). As shown in Fig. 4, when the substrate (GaN crystal substrate 10) is disposed in a concave portion of substrate support table 12, there may be a measurement point 120a on a surface 12a of a non-concave portion of substrate support table 12, and a measurement point 120b on a surface 12b of the concave portion of substrate support table 12.

In such a case, referring to Fig. 3, the plurality of displacement values respectively corresponding to the plurality of measurement points 10p on rear surface 10r of the substrate (GaN crystal substrate 10) can be detected with measurement points 120a and 120b removed as described below. Specifically, measurement points 120a and 120b can be removed by detecting only arbitrarily specified measurement point 100p which has distance L to laser displacement meter 15 satisfying the relation La < L < Lb, where La is a distance between laser displacement meter 15 and surface 12a of the non-concave portion of substrate support table 12, and Lb is a distance between laser displacement meter 15 and surface 12b of the concave portion of substrate support table 12. Consequently, the plurality of displacement values respectively corresponding to the plurality of measurement points 10p on rear surface 10r of the substrate (GaN crystal substrate 10) can be obtained.

Although there is no particular limitation on the noise removal step S2 as long as it removes noise contained in the plurality of displacement values, it is preferable to use a median filter for the step. Referring to Fig. 5, a median filter is a filter replacing a displacement value $z_{(a, b)}$ (meaning a displacement value corresponding to arbitrarily specified measurement point 100p; hereinafter the same applies) specified arbitrarily among the plurality of displacement values (meaning the plurality of displacement values respectively corresponding to the plurality of measurement points 10p on rear surface 10r of the substrate (GaN crystal substrate 10); hereinafter the same applies) by a median obtained when arranging the displacement value $z_{(a, b)}$ and a plurality of displacement values $z_{(a-1, b+1)}$, $z_{(a-1, b)}$, $z_{(a-1, b-1)}$, $z_{(a, b+1)}$, $z_{(a, b-1)}$, $z_{(a+1, b+1)}$, $z_{(a+1, b)}$, and $z_{(a+1, b-1)}$ neighboring the displacement value $z_{(a, b)}$ (meaning displacement values respectively corresponding to a plurality of measurement points 101p, 102p, 103p, 104p, 105p, 106p, 107p, 108p neighboring arbitrarily specified measurement point 100p; hereinafter the same applies) in increasing or decreasing order. In Fig. 5, the displacement value $z_{(a, b)}$ and the plurality of displacement values $z_{(a-1, b+1)}$, $z_{(a-1, b)}$, $z_{(a-1, b-1)}$, $z_{(a, b+1)}$, $z_{(a, b-1)}$, $z_{(a+1, b+1)}$, $z_{(a+1, b)}$, and $z_{(a+1, b-1)}$ neighboring the displacement value $z_{(a, b)}$ are arranged in the two-dimensional direction (the X direction and the Y direction) at constant pitch P.

Although Fig. 5 shows eight displacement values $z_{(a-1, b+1)}$, $z_{(a-1, b)}$, $z_{(a-1, b-1)}$, $z_{(a, b+1)}$, $z_{(a, b-1)}$, $z_{(a+1, b+1)}$, $z_{(a+1, b)}$, and $z_{(a+1, b-1)}$ neighboring and surrounding the arbitrarily specified displacement value as the plurality of neighboring displacement values (such a median filter is called an 8-neighborhood median filter), the number of the plurality of neighboring measuring points is not limited to eight. For example, 24 measuring points neighboring a displacement value can also be used (such a median filter is called an 24-neighborhood median filter).

There is no particular limitation on the outer peripheral portion removal step S3 as long as it calculates a plurality of displacement values for calculation by removing from the plurality of displacement values those respectively corresponding to the measurement points in an outer peripheral portion of the substrate. When using an 8-neighborhood median filter in the noise removal step S2, however, referring to Fig. 4, it is preferable to remove displacement values respectively corresponding to at least two measurement points 111p and 112p inward from an outer periphery 10e, as the displacement values respectively corresponding to the measurement points in the outer peripheral portion of the substrate (GaN crystal substrate 10), from the plurality of displacement values.

This is because, when an 8-neighborhood median filter is used in the noise removal step S2, referring to Fig. 4, at least one of eight displacement values neighboring a displacement value at a position one or two points inward from outer periphery 10e of the substrate (GaN crystal substrate 10) is a displacement value of surface 12a of the non-concave portion or surface 12b of the concave portion of substrate support table 12, and thus the above noise removal step fails to remove noise. With this manner, the displacement values respectively corresponding to the measurement points in the outer peripheral portion of the substrate are removed from the plurality of displacement values, and the plurality of displacement values for calculation is obtained.

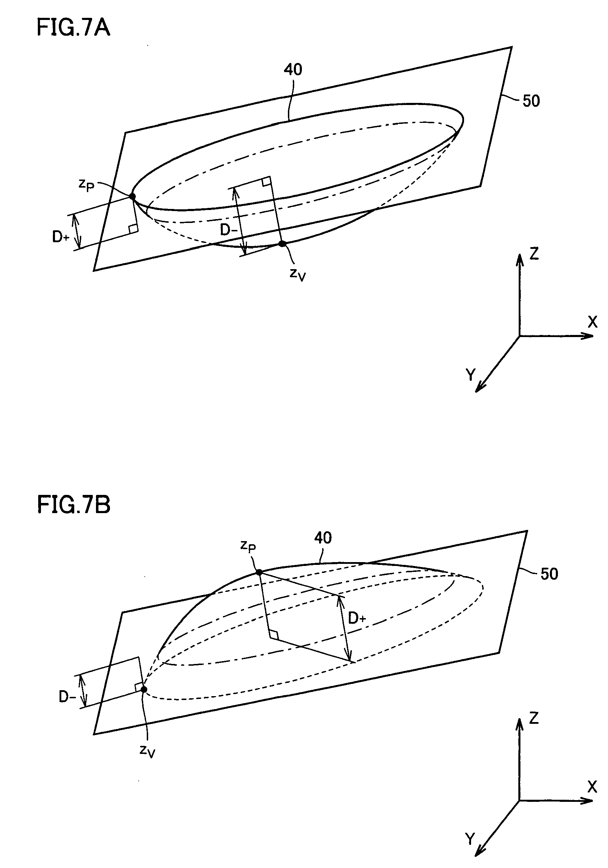

Referring to Figs. 7A and 7B, although there is no limitation on the smoothing step S4 as long as it smoothes the plurality of displacement values for calculation to calculate a warped surface 40, it is preferable to use a Gaussian filter for the step. A Gaussian filter is a filter replacing a displacement value $z_{(a, b)}$ specified arbitrarily among the plurality of displacement values for calculation by a weighted average value $z'_{(a, b)}$ of the displacement value $z_{(a, b)}$ and the plurality of displacement values $z_{(a-1, b+1)}, z_{(a-1, b)}, z_{(a-1, b-1)}, z_{(a, b+1)}, z_{(a, b-1)}, z_{(a+1, b+1)}, z_{(a+1, b)},$ and $z_{(a+1, b-1)}$ neighboring the displacement value $z_{(a, b)}$, using a Gaussian function f(x, y) as a weighting factor. With the smoothing described above, even for a rear surface having a high surface roughness (for example, a surface roughness Ra of not less than 50 nm), the warpage of the rear surface can be measured.

The two-dimensional Gaussian function f(x, y) is expressed by the following equation (1):

$$f(x,y) = \frac{1}{N^2} \exp\left\{ -\frac{(x-a)^2 + (y-b)^2}{2\sigma^2} \right\}$$

$$= \frac{1}{N^2} \exp\left\{ -\frac{(x-a)^2}{2\sigma^2} \right\} \cdot \exp\left\{ -\frac{(y-b)^2}{2\sigma^2} \right\} \tag{1}$$

where a and b are coordinate values of an arbitrarily specified measurement point in the X direction and the Y direction, respectively, $\sigma$ is a standard deviation ($\sigma^2$ is a dispersion), and N is a normalization constant.

As can be seen from equation (1), the greater the distance between a measurement point (x, y) and an arbitrarily specified measurement point (a, b) is, the smaller and less weighted the value of f(x, y) becomes. Further, the greater the value of $\sigma$ is, the smaller the difference in weighting resulting from the difference in the distance between the measurement point (x, y) and the arbitrarily specified measurement point (a, b) becomes.

Although eight displacement values $z_{(a-1, b+1)}, z_{(a-1, b)}, z_{(a-1, b-1)}, z_{(a, b+1)}, z_{(a, b-1)}, z_{(a+1, b+1)}, z_{(a+1, b)},$ and $z_{(a+1, b-1)}$ neighboring and surrounding an arbitrarily specified displacement value are used in the above as the plurality of neighboring displacement values (such a Gaussian filter is called an 8-neighborhood Gaussian filter), the number of the plurality of neighboring displacement values is not limited to eight. For example, 24 displacement values neighboring a displacement value can also be used (such a Gaussian filter is called an 24-neighborhood Gaussian filter).

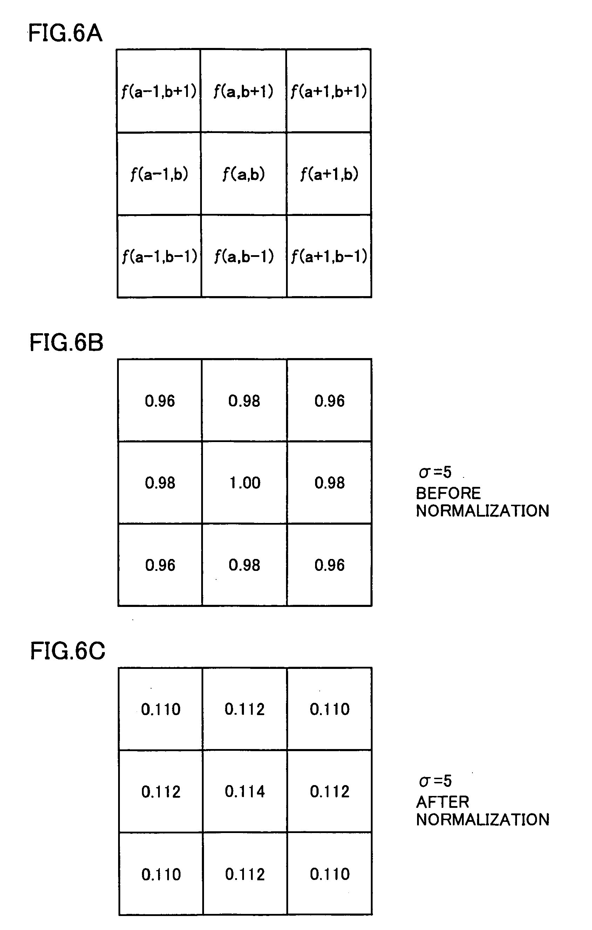

Using an 8-neighborhood Gaussian filter specifically means replacing the displacement value $z_{(a, b)}$ specified arbitrarily by the weighted average value $z'_{(a, b)}$ obtained by weighted averaging of the plurality of displacement values $z_{(a-1, b+1)}, z_{(a-1, b)}, z_{(a-1, b-1)}, z_{(a, b+1)}, z_{(a, b)}, z_{(a, b-1)}, z_{(a+1, b+1)}, z_{(a+1, b)},$ and $z_{(a+1, b-1)}$ shown in Fig. 5, with each of the values weighted by the Gaussian function f(x, y) (where x=a-1, a, a+1; y=b-1, b, b+1) as a coefficient shown in a kernel (meaning a matrix of coefficients of a filter for displacement values; hereinafter the same applies) of Fig. 6A. Specifically, it means obtaining the value $z'_{(a, b)}$ according to the following equation (2):

$$z'_{(a,b)} = \sum_{x=a-1}^{a+1} \sum_{y=b-1}^{b+1} f(x, y) \cdot z_{(x,y)}$$

$$= \frac{1}{N^2} \sum_{x=a-1}^{a+1} \sum_{y=b-1}^{b+1} \exp\left\{ -\frac{(x-a)^2 + (y-b)^2}{2\sigma^2} \right\} \cdot z_{(x,y)}$$

$$= \frac{1}{N^2} \sum_{x=a-1}^{a+1} \sum_{y=b-1}^{b+1} \exp\left\{ -\frac{(x-a)^2}{2\sigma^2} \right\} \cdot \exp\left\{ -\frac{(y-b)^2}{2\sigma^2} \right\} \cdot z_{(x,y)} \tag{2}$$

(where $N^2 = \sum_{x=a-1}^{a+1} \sum_{y=b-1}^{b+1} \exp\left\{ -\frac{(x-a)^2}{2\sigma^2} \right\} \cdot \exp\left\{ -\frac{(y-b)^2}{2\sigma^2} \right\}$)

The Gaussian function f(x, y) serving as a coefficient of the Gaussian filter is determined by the distance from the measurement point (a, b) of the arbitrarily specified displacement value to the measurement point (x, y) and by standard deviation $\sigma$. For example, Fig. 6B illustrates an arrangement of values of coefficients f(x, y) of an 8-neighborhood Gaussian filter with $\sigma$=5 before normalization, and Fig. 6C illustrates an arrangement of values of coefficients f(x, y) of an 8-neighborhood Gaussian filter with $\sigma$=5 after normalization. Normalization means correcting coefficients f(x, y) of a Gaussian filter such that a sum of the coefficients f(x, y) is 1, while maintaining ratios between the coefficients f(x, y).

Referring to Figs. 7A and 7B, although there is no particular limitation on the best fit plane calculation step S5 as long as it calculates a best fit plane 50 having the minimum distance to warped surface 40, it is preferable to calculate best fit plane 50 to minimize a sum of squares of every distance between best fit plane 50 and each point represented by each of the plurality of displacement values for calculation subjected to smoothing. With such a least square method, best fit plane 50 representing average inclination of entire rear surface 10r of the substrate (GaN crystal substrate 10) supported at three points can be obtained.

Referring to Figs. 7A and 7B, the warpage calculation step S6 calculates as warpage a sum of a distance $D_+$ from best fit plane 50 to a point represented by the greatest displacement value $z_p$ of warped surface 40 on one side with respect to best fit plane 50 and a distance $D_-$ from best fit plane 50 to a point represented by the greatest displacement value $z_v$ of warped surface 40 on the other side with respect to best fit plane 50. With this manner, the inclination of entire rear surface 10r of the substrate (GaN crystal substrate 10) represented as best fit plane 50 can be compensated for from warped surface 40, and the warpage of rear surface 10r of the substrate (GaN crystal substrate 10) can be measured accurately. Consequently, warpage $w_{(R)}$ of rear surface 10r of GaN crystal substrate 10 is calculated from $w_{(R)} = D_+ + D_-$.

Referring to Fig. 2, in the above method of measuring the warpage of the rear surface of the GaN crystal substrate, it is preferable to repeat an optimization cycle C1 including the smoothing step S4, the best fit plane calculation step S5, and the warpage calculation step S6 one or more times. By repeating such optimization cycle C1 one or more times, the warped surface of rear surface 10r of substrate 10 can be more smoothed, thereby reducing influence due to surface roughness, and thus the warpage of rear surface 10r can be measured more accurately. Although there is no particular limitation on the number of repeating optimization cycle C1, the number can be set such that a difference between a value of warpage before an optimization cycle and a value of warpage after the optimization cycle is preferably not more than 0.5 μm, and more preferably not more than 0.1 μm. Further, the number can be set such that a ratio of a difference between a value of warpage before an optimization cycle and a value of warpage after the optimization cycle to the value of warpage before the optimization cycle to the value of warpage before the optimization cycle is preferably not more than 0.05, and more preferably not more than 0.01.

Further, referring to Fig. 2, it is preferable that at least one noise removal step S2 is included in an interval between repeated optimization cycles C1, or after the smoothing step S4 in optimization cycle C1. By performing at least one noise removal step S2 at such timing, noise contained in the plurality of displacement values can be removed more effectively, and the warpage of rear surface 10r can be measured more accurately.

In the GaN crystal substrate in the present embodiment, it is preferable that the rear surface has a surface roughness $Ra_{(R)}$ satisfying $Ra_{(R)} \leq 10$ μm. Surface roughness Ra, also called an arithmetic mean roughness Ra, is a value obtained by sampling a portion having a reference length from a roughness curve in a direction of its mean line, summing up absolute values of deviations from a mean line of the sampled portion to a measurement curve, and calculating an average for the reference length. If the rear surface has a surface roughness $Ra_{(R)}$ satisfying $Ra_{(R)} > 10$ μm, when at least one group-III nitride crystal layer is grown as a semiconductor layer on a side of the crystal growth surface of the GaN crystal substrate, contact between the GaN crystal substrate and the susceptor becomes uneven, which results in uneven distribution of heat transferred from the susceptor to the GaN crystal substrate. From the viewpoint of reducing such uneven distribution of heat in the GaN crystal substrate, it is more preferable that the rear surface has a surface roughness $Ra_{(R)}$ satisfying $Ra_{(R)} \leq 6$ μm.

On the other hand, if surface roughness $Ra_{(R)}$ of the rear surface is too low, a heat-radiating light beam emitted from the susceptor heated to a high temperature is reflected by the rear surface, and the heat-radiating light beam is less absorbed into the substrate, reducing heating efficiency of the substrate. In view of the above, surface roughness $Ra_{(R)}$ of the rear surface satisfies $Ra_{(R)} \geq 1$ μm, and preferably satisfies $Ra_{(R)} \geq 2$ μm.

In the GaN crystal substrate in the present embodiment, it is preferable that the rear surface has a surface roughness $Ry_{(R)}$ satisfying $Ra_{(R)} \leq 75$ μm. Surface roughness Ry, also called the maximum height Ry, is a value obtained by sampling a portion having a reference length from a roughness curve in a direction of its mean line, and summing a height from a mean line of the sampled portion to the highest crest and a depth from the mean line of the sampled portion to the lowest valley. If the rear surface has a surface roughness $Ry_{(R)}$ satisfying $Ry_{(R)} > 75$ μm, when at least one group-III nitride crystal layer is grown as a semiconductor layer on the side of the crystal growth surface of the GaN crystal substrate, contact between the GaN crystal substrate and the susceptor becomes uneven, which results in uneven distribution of heat transferred from the susceptor to the GaN crystal substrate. From the viewpoint of reducing such uneven distribution of heat in the GaN crystal substrate, it is more preferable that the rear surface has a surface roughness $Ry_{(R)}$ satisfying $Ry_{(R)} \leq 50$ μm.

On the other hand, if surface roughness $Ry_{(R)}$ of the rear surface is too low, a heat-radiating light beam emitted from the susceptor heated to a high temperature is reflected by the rear surface, and the heat-radiating light beam is less absorbed into the substrate, reducing heating efficiency of the substrate. In view of the above, surface roughness $Ry_{(R)}$ of the rear surface preferably satisfies $Ry_{(R)} \geq 3$ μm, and more preferably satisfies $Ry_{(R)} \geq 10$ μm.

In the GaN crystal substrate in the present embodiment, the smaller an absolute value of warpage $w_{(C)}$ and surface roughnesses $Ra_{(C)}$ and $Ry_{(C)}$ of the crystal growth surface of the substrate are, the higher the crystallinity of the group-III nitride crystal layer grown as a semiconductor layer on the side of the crystal growth surface becomes. In view of the above, warpage $w_{(C)}$ of the crystal growth surface of the substrate preferably satisfies -50 $\mu$m $\leq w_{(C)} \leq$ 50 $\mu$m, and more preferably satisfies -35 $\mu$m $\leq w_{(C)} \leq$ 40 $\mu$m. Further, surface roughness $Ra_{(C)}$ of the crystal growth surface preferably satisfies $Ra_{(C)} \leq$ 10 nm, and more preferably satisfies $Ra_{(C)} \leq$ 5 nm. Furthermore, surface roughness $Ry_{(C)}$ of the crystal growth surface preferably satisfies $Ry_{(C)} \leq$ 60 nm, and more preferably satisfies $Ry_{(C)} \leq$ 30 nm. It is to be noted that, referring to Figs. 1A and 1B, warpage $w_{(C)}$ is defined as a difference in height between a displacement value $z_{CP}$ at the most convex portion and a displacement value $z_{CV}$ at the most concave portion of crystal growth surface 10c.

Preferably, the GaN crystal substrate in the present embodiment has a higher absorption coefficient for the heat-radiating light beam in order to improve the heating efficiency of the substrate. In view of the above, the GaN crystal substrate in the present embodiment preferably has an absorption coefficient for a light beam having a peak wavelength of 450 nm to 550 nm of not less than 1.5 cm$^{-1}$ and not more than 10 cm$^{-1}$. If the absorption coefficient for such a light beam is lower than 1.5 cm$^{-1}$, the light beam passes through the substrate and is not absorbed, and thus the heating efficiency of the substrate is reduced. If the absorption coefficient for such a light beam is higher than 10 cm$^{-1}$, the substrate includes many impurities and thus has a low crystallinity.

Further, the GaN crystal substrate in the present embodiment preferably has a heat conductivity of not less than 160 W/mK in order to reduce heat distribution in the substrate. Furthermore, the GaN crystal substrate in the present embodiment preferably has a heat expansion coefficient of not less than $3\times10^{-6}$K$^{-1}$ and not more than $6\times10^{-6}$K$^{-1}$ in order to suppress deformation of the substrate when a temperature is increased or decreased.

Second Embodiment

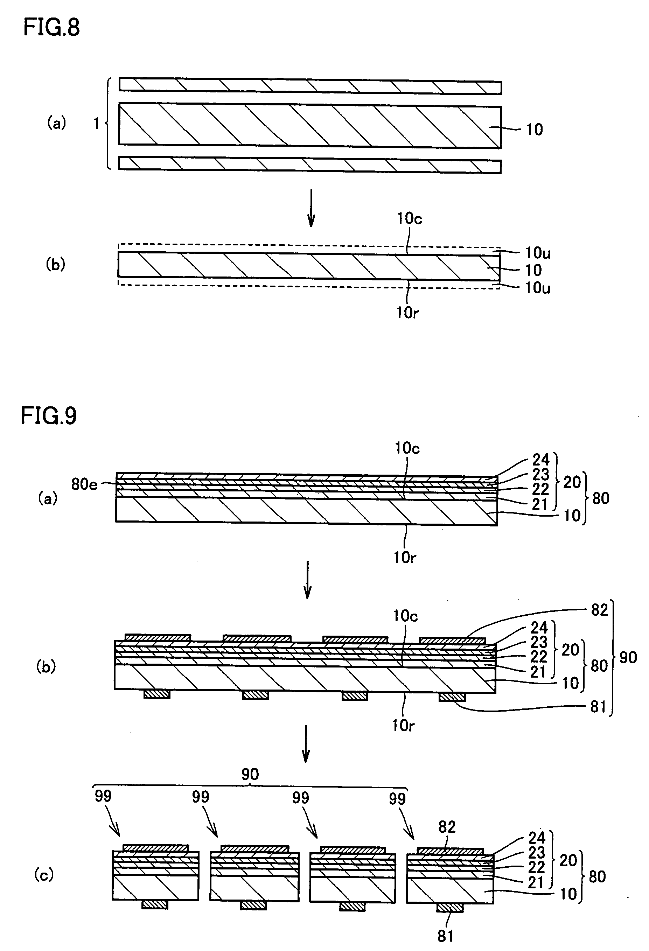

Referring to Fig. 8, a method of manufacturing a GaN crystal substrate in accordance with the present invention is a method of manufacturing the GaN crystal substrate in the first embodiment, including the steps of cutting GaN crystal substrate 10 out of a GaN crystal 1 (see Fig. 8(a)) and processing rear surface 10r of GaN crystal substrate 10 (see Fig. 8(b)), and the step of processing rear surface 10r of GaN crystal substrate 10 includes at least one of the steps of grinding rear surface 10r, lapping rear surface 10r, and etching rear surface 10r.

Referring to Fig. 8(a), the step of cutting GaN crystal substrate 10 out of GaN crystal 1 is the step of cutting GaN crystal substrate 10 of a predetermined shape out of grown GaN crystal 1 using an inner diameter blade, an outer diameter blade, a wire saw, or the like. Although there is no particular limitation on the method of growing GaN crystal 1, vapor phase epitaxy such as HVPE or MOVPE is preferably used because a large-sized crystal having a diameter of not less than 5.08 cm (2 inches) is obtained relatively in a short period or time.

Referring to Fig. 8(b), the step of processing rear surface 10r of GaN crystal substrate 10 includes at least one of the step of grinding rear surface 10r of GaN crystal substrate 10 (the grinding step), the step of lapping rear surface 10r of GaN crystal substrate 10 (the lapping step), and etching rear surface 10r of GaN crystal substrate 10 (the etching step). By performing the step of processing the rear surface of the GaN crystal substrate including the steps described above, a GaN crystal substrate in which a rear surface opposite to a crystal growth surface has a warpage $w_{(R)}$ satisfying -35 $\mu$m $\leq w_{(R)} \leq$ 45 $\mu$m can be obtained. Further, by adjusting a grinding condition, a lapping condition, and/or an etching condition, a GaN crystal substrate having a rear surface with a surface roughness $Ra_{(R)}$ satisfying $Ra_{(R)} \leq$ 10 $\mu$m and/or a surface roughness $Ry_{(R)}$ satisfying $Ry_{(R)} \leq$ 75 $\mu$m can be obtained.

It is to be noted that grinding is to rotate fixed abrasive grains made by fixing abrasive grains with a bond at a high speed, bring the fixed abrasive grains into contact with an object, and scrape off a surface of the object. Such grinding provides a rough surface. When the rear surface of the GaN crystal substrate is subjected to grinding, fixed abrasive grains including abrasive grains formed of SiC, Al$_2$O$_3$, diamond, CBN (cubic boron nitride; hereinafter the same applies) or the like having a hardness higher than that of the GaN crystal, and having a grain size of about not less than 10 $\mu$m and not more than 100 $\mu$m are preferably used.

Further, lapping is to bring a rotating surface plate and a rotating object into contact with each other with free abrasive grains (meaning abrasive grains which are not fixed; hereinafter the same applies) interposed therebetween or bring rotating fixed abrasive grains and a rotating object into contact with each other, and rub a surface of the object. Such lapping provides a surface having a surface roughness lower than that obtained by grinding and higher than that obtained by polishing. When the rear surface of the GaN crystal substrate is subjected to lapping, abrasive grains formed of SiC, Al$_2$O$_3$, diamond, CBN or the like having a hardness higher than that of the GaN crystal, and having a grain size of about not less than 0.5 $\mu$m and not more than 15 $\mu$m are preferably used.

Furthermore, etching is to chemically or physically erode a surface of an object to remove an affected layer and residues left after the steps of cutting the object and subsequently grinding and/or lapping a surface of the object (such as shavings left after cutting, grinding and lapping, abrasive grains, and a wax) (10u: an etched portion). Also by such etching, surface roughness is maintained. When the rear surface of the GaN crystal substrate is subjected to etching, wet etching using an etching agent is preferably performed. Examples of a preferable etching agent include a

mixed solution of $NH_3$ and $H_2O_2$, a KOH solution, a NaOH solution, an HCl solution, an $H_2SO_4$ solution, an $H_3PO_4$ solution, a mixed solution of $H_3PO_4$ and $H_2SO_4$, and the like. Water is used as a preferable solvent for the solutions and the mixed solutions described above. Further, the etching agent can also be diluted with a solvent such as water as appropriate for use.

In the method of manufacturing the GaN crystal substrate in the present embodiment, the step of processing the crystal growth surface of the GaN crystal substrate is performed. In order to manufacture a semiconductor device having excellent properties, it is necessary to form at least one group-III nitride crystal layer having good crystallinity as a semiconductor layer on the side of the crystal growth surface. Consequently, it is preferable that the crystal growth surface of the GaN crystal substrate has warpage $w_{(C)}$ satisfying -50 $\mu$m $\leq w_{(C)} \leq$ 50 $\mu$m, surface roughness $Ra_{(C)}$ satisfying $Ra_{(C)} \leq$ 10 nm, and surface roughness $Ry_{(C)}$ satisfying $Ry_{(C)} \leq$ 60 nm.

In order to obtain a crystal growth surface having warpage $w_{(C)}$, surface roughness $Ra_{(C)}$, and surface roughness $Ry_{(C)}$ described above, a polishing step is performed in the step of processing the crystal growth surface of the GaN crystal substrate cut out of the GaN crystal, in addition to a grinding step, a lapping step, and/or an etching step similar to the grinding step, the lapping step, and/or the etching step in the step of processing the rear surface.

Polishing is to bring a rotating polishing pad and a rotating object into contact with each other with free abrasive grains interposed therebetween or bring rotating fixed abrasive grains and a rotating object into contact with each other, and finely rub and smooth a surface of the object. Such polishing provides a crystal growth surface having a surface roughness lower than that obtained by lapping.

Although there is no particular limitation on the technique of polishing as described above, mechanical polishing or chemical mechanical polishing (hereinafter referred to as CMP) is preferably used. Mechanical polishing or CMP is a technique bringing a rotating polishing pad and a rotating object into contact with each other, with a slurry containing abrasive grains interposed therebetween, to mechanically or chemically and mechanically polish a surface of the object. As the abrasive grains, fine particles having an average grain size of not less than 0.1 $\mu$m and not more than 3 $\mu$m and formed of SiC, $Si_3N_4$, $Al_2O_3$, diamond, CBN or the like having a hardness higher than that of GaN, or formed of $SiO_2$, CuO, $TiO_2$, ZnO, NiO, $Cr_2O_3$, $Fe_2O_3$, CoO, MnO or the like having a hardness lower than that of GaN are used alone or in combination in order to reduce surface roughnesses Ra and Ry. Further, it is preferable that the slurry is acidic having pH $\leq$ 5 or basic having PH $\geq$ 9, or is added with an oxidizer such as hydrogen peroxide ($H_2O_2$), dichloroisocyanurate, nitric acid, potassium permanganate, or copper chloride and thus has an improved ORP (oxidation-reduction potential) (for example, ORP $\geq$ 400 mV), in order to improve a chemical polishing effect.

Third Embodiment

Referring to Fig. 9, an embodiment of a method of manufacturing a semiconductor device in accordance with the present invention includes the step of preparing GaN crystal substrate 10 in the first embodiment as a substrate and growing at least one group-III nitride crystal layer 20 on the side of crystal growth surface 10c of GaN crystal substrate 10. With such a manufacturing method, group-III nitride crystal layer 20 can be formed evenly and stably as a semiconductor layer on the side of crystal growth surface 10c of GaN crystal substrate 10, and thus a semiconductor device 99 having excellent properties can be obtained.

More specifically, referring to Fig. 9(a), in the method of manufacturing the semiconductor device in the present embodiment, an n-type GaN layer 21, an $In_{0.2}Ga_{0.8}N$ layer 22, an $Al_{0.2}Ga_{0.8}N$ layer 23, and a p-type GaN layer 24 are formed in order as group-III nitride crystal layer 20 on crystal growth surface 10c of GaN crystal substrate 10 to obtain a wafer 80 including stacked semiconductor layers (hereinafter referred to as a semiconductor-layer-stacked wafer 80). Next, referring to Fig. 9(b), an n-side electrode 81 is formed on rear surface 10r of GaN crystal substrate 10 of semiconductor-layer-stacked wafer 80, and a p-side electrode 82 is formed on an upper surface of group-III nitride crystal layer 20 (that is, an upper surface of p-type GaN layer 24) to obtain a semiconductor device wafer 90. Next, referring to Fig. 9(c), semiconductor device wafer 90 is divided into chips to obtain an LED (light emitting diode) as semiconductor device 99.

Examples

First Comparative Example

1. Manufacturing of a GaN crystal substrate

Referring to Fig. 8(a), GaN crystal substrate 10 measuring 5.08 cm (2 inches) in diameter by 550 $\mu$m in thickness was cut out of GaN crystal 1 grown by HVPE. Referring to Fig. 8(b), rear surface 10r and crystal growth surface 10c of GaN crystal substrate 10 were processed as described below. The rear surface was subjected to grinding using fixed abrasive grains made by fixing CBN abrasive grains having a grain size of 125 $\mu$m with a bond (the grinding step), lapping using diamond abrasive grains having a grain size of 24 $\mu$m (the lapping step), and etching using a mixed aqueous solution of $NH_3$ and $H_2O_2$ in which 30% by mass ammonia water, 40% by mass hydrogen peroxide water, and pure water were mixed in the volume ratio of 1:1:2 (the etching step). The crystal growth surface was subjected to grinding using fixed abrasive grains made by fixing CBN abrasive grains having an average grain size of 125 $\mu$m with a bond (the grinding step), lapping using three types of SiC abrasive grains having an average grain size of 20 $\mu$m, 10 $\mu$m, and 5 $\mu$m, respectively, in order (the lapping step), etching using a 30% by mass NaOH solution (the etching step), and chemical mechanical polishing using a slurry having pH=12 and ORP =450 mV and containing $TiO_2$ abrasive grains having an average grain size of 1 $\mu$m (the polishing step).

2. Measurement of warpages and surface roughnesses of the rear surface and the crystal growth surface of the GaN crystal substrate

Referring to Figs. 1A and 1B, warpage $w_{(R)}$ of rear surface 10r of GaN crystal substrate 10 subjected to the above processing was measured as described below, using a laser displacement meter employing the laser focus technique (LT-9010 (laser output unit) and LT-9500 (laser control unit) manufactured by Keyence Corporation), an XY position controller (CP-500 manufactured by COMS Co., Ltd.), and a high-speed analog voltage data collection apparatus (CA-800 manufactured by COMS Co., Ltd.). A red color semiconductor laser having a laser wavelength of 670 nm was used for the laser displacement meter.

Referring to Figs. 2 to 4, firstly GaN crystal substrate 10 was disposed on substrate support table 12 such that the outer peripheral portion of crystal growth surface 10c thereof was supported by three supporting portions 12h. Then, laser displacement meter 15 was used to detect a plurality of displacement values respectively corresponding to the plurality of measurement points 10p on rear surface 10r of GaN crystal substrate 10 (the substrate detection step S1). On this occasion, measurement points 10p were arranged with pitch P of 700 $\mu$m, and a plurality of displacement values respectively corresponding to about 5000 measurement points 10p was measured. Next, noise contained in the plurality of displacement values was removed using an 8-neighborhood median filter (the noise removal step S2). Thereafter, a plurality of displacement values for calculation was calculated by removing from the plurality of displacement values those respectively corresponding to up to three measurement points inward from outer periphery 10e of GaN crystal substrate 10 (the outer peripheral portion removal step S3).

Then, the plurality of displacement values for calculation was smoothed using the 8-neighborhood Gaussian filter with $\sigma$=5 after normalization shown in Fig. 6C to calculate a warped surface (the smoothing step S4). Next, a best fit plane was calculated to minimize the sum of squares of every distance between best fit plane 50 and each point represented by each of the plurality of displacement values for calculation subjected to smoothing (the best fit plane calculation step S5). Thereafter, the sum of a distance from the best fit plane to a point represented by the greatest displacement value of the warped surface on one side with respect to the best fit plane and a distance from the best fit plane to a point represented by the greatest displacement value of the warped surface on the other side with respect to the best fit plane was calculated as warpage (the warpage calculation step S6). The warpage calculated as described above was 57.4 $\mu$m.

Next, noise contained in the plurality of displacement values for calculation was removed using the 8-neighborhood median filter again (the noise removal step S2). Thereafter, optimization cycle C1 performing the smoothing step S4, the best fit plane calculation step S5, and the warpage calculation step S6 in this order was repeated once. The warpage calculated as described above was 54.9 $\mu$m.

Then, the above optimization cycle was repeated once more. The warpage calculated as described above was 54.5 $\mu$m, having a difference of not more than 0.5 $\mu$m from the previously calculated warpage. Therefore, the optimization cycle was ended, and warpage $w_{(R)}$ of the rear surface of the GaN crystal substrate was calculated at 54.5 $\mu$m. Further, when warpage $w_{(C)}$ of crystal growth surface 10c of GaN crystal substrate 10 subjected to the above processing was measured using a flatness tester employing optical interferometry, warpage $w_{(C)}$ was 48.2 $\mu$m.

Further, surface roughness $Ra_{(R)}$ of rear surface 10r and surface roughness $Ra_{(C)}$ of crystal growth surface 10c of GaN crystal substrate 10 subjected to the above processing were calculated by: performing measurement in a range of 110 $\mu$m $\times$ 80 $\mu$m using a 3D-SEM (three-dimensional scanning electron microscope) and in a range of 750 $\mu$m $\times$ 700 $\mu$m using the laser displacement meter employing the laser focus technique, respectively; sampling a portion having a reference length from a roughness curve arbitrarily specified in each measurement range, in a direction of a mean line of the roughness curve; summing up absolute values of deviations from a mean line of the sampled portion to a measurement curve; and calculating an average for the reference length. As a result, $Ra_{(R)}$=11.8 $\mu$m and $Ra_{(C)}$=4 nm were obtained.

Furthermore, surface roughness $Ry_{(R)}$ of rear surface 10r and surface roughness $Ry_{(C)}$ of crystal growth surface 10c of GaN crystal substrate 10 subjected to the above processing were calculated by: performing measurement in a range of 750 $\mu$m $\times$ 700 $\mu$m using the laser displacement meter employing the laser focus technique; sampling a portion having a reference length from a roughness curve arbitrarily specified in each measurement range, in a direction of a mean line of the roughness curve; and summing a height from a mean plane of the sampled portion to the highest crest and a depth from the mean plane of the sampled portion to the lowest valley. As a result, $Ry_{(R)}=89.2$ $\mu$m and $Ry_{(C)}=38$ nm were obtained.

Further, an absorption coefficient of GaN crystal substrate 10 subjected to the above processing for a light beam having a peak wavelength of 450 nm to 550 nm was measured using a spectrometer, and it was found that GaN crystal substrate 10 had an absorption coefficient of 6.8 cm$^{-1}$. Furthermore, heat conductivity of GaN crystal substrate 10 was measured in a range of 18 mm $\times$ 18 mm by two-dimensional measurement using laser flash, and it was found that GaN crystal substrate 10 had a heat conductivity of 165 W/mK Further, a heat expansion coefficient of GaN crystal substrate 10 was measured by laser interferometry, and it was found that GaN crystal substrate 10 had a heat expansion coefficient of $4.2\times10^{-6}K^{-1}$.

3. Manufacturing of a semiconductor device

Referring to Fig. 9(a), 5 $\mu$m thick n-type GaN layer 21, 3 nm thick $In_{0.2}Ga_{0.8}N$ layer 22, 60 nm thick $Al_{0.2}Ga_{0.8}N$ layer 23, and 150 nm thick p-type GaN layer 24 were grown in order as group-III nitride crystal layer 20 on crystal growth surface 10c of GaN crystal substrate 10 by means of MOVPE, to obtain semiconductor-layer-stacked wafer 80. Light emission intensity distribution in the obtained semiconductor-layer-stacked wafer 80 was evaluated by photoluminescence (hereinafter referred to as PL).

Specifically, a laser beam having an energy greater than that of a bandgap of any layer in group-III nitride crystal layer 20 (a He-Cd laser beam having a peak wavelength of 325 nm) was applied to a plurality of measurement points on a main surface on the side of group-III nitride crystal layer 20 of semiconductor-layer-stacked wafer 80 having a diameter of 5.08 cm (2 inches), and intensity of excited light emission was measured. The measurement points were disposed all over the main surface on the side of group-III nitride crystal layer 20 of semiconductor-layer-stacked wafer 80, and arranged with a pitch of 1 mm in the two-dimensional direction parallel to the main surface. Light emission intensity distribution in semiconductor-layer-stacked wafer 80 was evaluated using a percentage of a light emission intensity $I_E$ in an outer peripheral portion ranging from an outer periphery 80e to 5 mm inward therefrom having the smallest light emission intensity to a light emission intensity $I_C$ in a central portion having the greatest light emission intensity ($100\times I_E/I_C$; hereinafter referred to as a relative light emission intensity in the outer peripheral portion). The smaller the value of the relative light emission intensity in the outer peripheral portion is, the larger the light emission intensity distribution is. The greater the value of the relative light emission intensity in the outer peripheral portion is, the smaller the light emission intensity distribution is. The relative light emission intensity in the outer peripheral portion in the present comparative example was 0.06, meaning that the light emission intensity distribution was large. Table 1 shows the result.

Next, referring to Fig. 9(b), n-side electrode 81 measuring 80 $\mu$m in diameter by 100 nm in thickness was formed on rear surface 10r of GaN crystal substrate 10 at a position to be a central portion of a chip when semiconductor-layer-stacked wafer 80 was cut into chips, and 100 nm thick p-side electrode 82 was formed on the upper surface of p-type GaN layer 24. Thereby, semiconductor device wafer 90 was obtained.

Next, referring to Fig. 9(c), semiconductor device wafer 90 was divided into chips each measuring 400 $\mu$m by 400 $\mu$m, and thus an LED serving as semiconductor device 99 was obtained. Obtained semiconductor device 99 had a yield (meaning a percentage of the number of semiconductor devices having a predetermined light emission intensity and obtained as products to the total number of semiconductor devices produced as chips; hereinafter the same applies) of as low as 25%. Table 1 shows the result.

The first example and sixth example are not part of the invention as claimed.

First Example

A GaN crystal substrate was manufactured as in the first comparative example except that, during manufacturing the GaN crystal substrate, a rear surface thereof was subjected to grinding using fixed abrasive grains made by fixing CBN abrasive grains having a grain size of 84 $\mu$m with a bond (the grinding step), lapping using SiC abrasive grains having a grain size of 12 $\mu$m (the lapping step), and etching using a mixed aqueous solution of $H_3PO_4$ and $H_2SO_4$ in which an 85% by mass phosphoric acid aqueous solution and a 90% by mass sulfuric acid aqueous solution were mixed in the volume ratio of 1:1 (the etching step). Then, warpages and surface roughnesses of the rear surface and the crystal growth surface of the GaN crystal substrate were measured. The rear surface of the obtained GaN crystal substrate had a warpage $w_{(R)}$ of -22.8 $\mu$m, a surface roughness $Ra_{(R)}$ of 10.2 $\mu$m, and a surface roughness $Ra_{(R)}$ of 78.5 $\mu$m. The crystal growth surface of the GaN crystal substrate had a warpage $w_{(C)}$ of -17.4 $\mu$m, and had surface roughnesses $Ra_{(C)}$ and $Ry_{(C)}$ similar to those in the first comparative example. The GaN crystal substrate had an absorption coefficient for a light beam having a peak wavelength of 450 nm to 550 nm, a heat conductivity, and a heat expansion coefficient similar to those in the first comparative example.

Next, the GaN crystal substrate obtained in the present example was used to prepare a semiconductor-layer-stacked wafer and then a semiconductor device wafer, and finally manufacture a semiconductor device, as in the first comparative example. The semiconductor-layer-stacked wafer of the present example had a high relative light emission intensity in the outer peripheral portion of 0.16 (meaning that the light emission intensity distribution was small). Further, the semiconductor device had a high yield of 44%. Table 1 shows the result.

Second Example

A GaN crystal substrate was manufactured as in the first comparative example except that, during manufacturing the GaN crystal substrate, a rear surface thereof was subjected to grinding using fixed abrasive grains made by fixing $Al_2O_3$ abrasive grains having a grain size of 63 $\mu$m with a bond (the grinding step), lapping using $Al_2O_3$ abrasive grains having a grain size of 8 $\mu$m (the lapping step), and etching using a 25% by mass KOH aqueous solution (the etching step). Then, warpages and surface roughnesses of the rear surface and the crystal growth surface of the GaN crystal substrate were measured. The rear surface of the obtained GaN crystal substrate had a warpage $w_{(R)}$ of -19.1 $\mu$m, a surface roughness $Ra_{(R)}$ of 6.8 $\mu$m, and a surface roughness $Ry_{(R)}$ of 55 $\mu$m. The crystal growth surface of the GaN crystal substrate had a warpage $w_{(C)}$ of -16.7 $\mu$m, and had surface roughnesses $Ra_{(C)}$ and $Ry_{(C)}$ similar to those in the first comparative example. The GaN crystal substrate had an absorption coefficient for a light beam having a peak wavelength of 450 nm to 550 nm, a heat conductivity, and a heat expansion coefficient similar to those in the first comparative example.

Next, the GaN crystal substrate obtained in the present example was used to prepare a semiconductor-layer-stacked wafer and then a semiconductor device wafer, and finally manufacture a semiconductor device, as in the first comparative example. The semiconductor-layer-stacked wafer of the present example had a high relative light emission intensity in the outer peripheral portion of 0.29 (meaning that the light emission intensity distribution was small). Further, the semiconductor device had a high yield of 57%. Table 1 shows the result.

Third Example

A GaN crystal substrate was manufactured as in the first comparative example except that, during manufacturing the GaN crystal substrate, a rear surface thereof was subjected to grinding using fixed abrasive grains made by fixing diamond abrasive grains having a grain size of 32 $\mu$m with a bond (the grinding step), and etching using a 25% by mass KOH aqueous solution (the etching step). Then, warpages and surface roughnesses of the rear surface and the crystal growth surface of the GaN crystal substrate were measured. The rear surface of the obtained GaN crystal substrate had a warpage $w_{(R)}$ of -3.4 $\mu$m, a surface roughness $Ra_{(R)}$ of 4.9 $\mu$m, and a surface roughness $Ry_{(R)}$ of 31.9 $\mu$m. The crystal growth surface of the GaN crystal substrate had a warpage $w_{(C)}$ of -4.6 $\mu$m, and had surface roughnesses $Ra_{(C)}$ and $Ry_{(C)}$ similar to those in the first comparative example. The GaN crystal substrate had an absorption coefficient for a light beam having a peak wavelength of 450 nm to 550 nm, a heat conductivity, and a heat expansion coefficient similar to those in the first comparative example.

Next, the GaN crystal substrate obtained in the present example was used to prepare a semiconductor-layer-stacked wafer and then a semiconductor device wafer, and finally manufacture a semiconductor device, as in the first comparative example. The semiconductor-layer-stacked wafer of the present example had a high relative light emission intensity in the outer peripheral portion of 0.41 (meaning that the light emission intensity distribution was small). Further, the semiconductor device had a high yield of 70%. Table 1 shows the result.

Fourth Example

A GaN crystal substrate was manufactured as in the first comparative example except that, during manufacturing the GaN crystal substrate, a rear surface thereof was subjected to grinding using fixed abrasive grains made by fixing SiC abrasive grains having a grain size of 30 $\mu$m with a bond (the grinding step), lapping using diamond abrasive grains having a grain size of 6 $\mu$m (the lapping step), and etching using a mixed aqueous solution of $NH_3$ and $H_2O_2$ in which 30% by mass ammonia water, 40% by mass hydrogen peroxide water, and pure water were mixed in the volume ratio of 1:1:6 (the etching step). Then, warpages and surface roughnesses of the rear surface and the crystal growth surface of the GaN crystal substrate were measured. The rear surface of the obtained GaN crystal substrate had a warpage $w_{(R)}$ of 4.8 $\mu$m, a surface roughness $Ra_{(R)}$ of 3.8 $\mu$m, and a surface roughness $Ry_{(R)}$ of 23.8 $\mu$m. The crystal growth surface of the GaN crystal substrate had a warpage $w_{(C)}$ of 2.8 $\mu$m, and had surface roughnesses $Ra_{(C)}$ and $Ry_{(C)}$ similar to those in the first comparative example. The GaN crystal substrate had an absorption coefficient for a light beam having a peak wavelength of 450 nm to 550 nm, a heat conductivity, and a heat expansion coefficient similar to those in the first comparative example.

Next, the GaN crystal substrate obtained in the present example was used to prepare a semiconductor-layer-stacked wafer and then a semiconductor device wafer, and finally manufacture a semiconductor device, as in the first comparative example. The semiconductor-layer-stacked wafer of the present example had a high relative light emission intensity in the outer peripheral portion of 0.38 (meaning that the light emission intensity distribution was small). Further, the semiconductor device had a high yield of 68%. Table 1 shows the result.

Fifth Example

A GaN crystal substrate was manufactured as in the first comparative example except that, during manufacturing the GaN crystal substrate, a rear surface thereof was subjected to grinding using fixed abrasive grains made by fixing SiC abrasive grains having a grain size of 37 $\mu$m with a bond (the grinding step), and etching using a 25% by mass KOH aqueous solution (the etching step). Then, warpages and surface roughnesses of the rear surface and the crystal growth surface of the GaN crystal substrate were measured. The rear surface of the obtained GaN crystal substrate had a warpage $w_{(R)}$ of 9.9 $\mu$m, a surface roughness $Ra_{(R)}$ of 5.5 $\mu$m, and a surface roughness $Ry_{(R)}$ of 38.7 $\mu$m. The crystal growth surface of the GaN crystal substrate had a warpage $w_{(C)}$ of 10.4 $\mu$m, and had surface roughnesses $Ra_{(C)}$ and $Ry_{(C)}$ similar to those in the first comparative example. The GaN crystal substrate had an absorption coefficient for a light beam having a peak wavelength of 450 nm to 550 nm, a heat conductivity, and a heat expansion coefficient similar to those in the first comparative example.

Next, the GaN crystal substrate obtained in the present example was used to prepare a semiconductor-layer-stacked wafer and then a semiconductor device wafer, and finally manufacture a semiconductor device, as in the first comparative example. The semiconductor-layer-stacked wafer of the present example had a high relative light emission intensity in the outer peripheral portion of 0.30 (meaning that the light emission intensity distribution was small). Further, the semiconductor device had a high yield of 65%. Table 1 shows the result.

Sixth Example

A GaN crystal substrate was manufactured as in the first comparative example except that, during manufacturing the GaN crystal substrate, a rear surface thereof was subjected to grinding using fixed abrasive grains made by fixing diamond abrasive grains having a grain size of 74 $\mu$m with a bond (the grinding step), lapping using CBN abrasive grains having a grain size of 15 $\mu$m (the lapping step), and etching using an 85% by mass $H_3PO_4$ aqueous solution (the etching step). Then, warpages and surface roughnesses of the rear surface and the crystal growth surface of the GaN crystal substrate were measured. The rear surface of the obtained GaN crystal substrate had a warpage $w_{(R)}$ of 19.3 $\mu$m, a surface roughness $Ra_{(R)}$ of 10.8 $\mu$m, and a surface roughness $Ry_{(R)}$ of 81.9 $\mu$m. The crystal growth surface of the GaN crystal substrate had a warpage $w_{(C)}$ of 23.0 $\mu$m, and had surface roughnesses $Ra_{(C)}$ and $Ry_{(C)}$ similar to those in the first comparative example. The GaN crystal substrate had an absorption coefficient for a light beam having a peak wavelength of 450 nm to 550 nm, a heat conductivity, and a heat expansion coefficient similar to those in the first comparative example.

Next, the GaN crystal substrate obtained in the present example was used to prepare a semiconductor-layer-stacked wafer and then a semiconductor device wafer, and finally manufacture a semiconductor device, as in the first comparative example. The semiconductor-layer-stacked wafer of the present example had a high relative light emission intensity in the outer peripheral portion of 0.26 (meaning that the light emission intensity distribution was small). Further, semiconductor device had a high yield of 61%. Table 1 shows the result.

[Table 1]

| | | | Comparative Example 1 | Example 1 | Example 2 | Example 3 | Example 4 | Example 5 | Example 6 |
|---|---|---|---|---|---|---|---|---|---|
| Rear Surface Processing Conditions | Abrasive Grains for Grinding | Composition | CBN | CBN | $Al_2O_3$ | Diamond | SiC | SiC | Diamond |
| | | Grain size (μm) | 125 | 84 | 63 | 32 | 30 | 37 | 74 |
| | Abrasive Grains for Lapping | Composition | Diamond | SiC | $Al_2O_3$ | — | Diamond | — | CBN |
| | | Grain size (μm) | 24 | 12 | 8 | — | 6 | — | 15 |
| | Etching Agent | | $NH_3 + H_2O_2$ | $H_3PO_4 + H_2SO_4$ | KOH | KOH | $NH_3 + H_2O_2$ | KOH | $H_3PO_4$ |
| Properties of Rear Surface of Substrate | Warpage $w_{(R)}$ (μm) | | 54.5 | -22.8 | -19.1 | -3.4 | 4.8 | 9.9 | 19.3 |
| | Surface Roughness $Ra_{(R)}$ (μm) | | 11.8 | 10.2 | 6.8 | 4.9 | 3.8 | 5.5 | 10.8 |
| | Surface Roughness $Ry_{(R)}$ (μm) | | 89.2 | 78.5 | 55 | 31.9 | 23.8 | 38.7 | 81.9 |
| Relative Light Emission Intensity in Outer Peripheral Portion of Wafer | | | 0.06 | 0.16 | 0.29 | 0.41 | 0.38 | 0.30 | 0.26 |
| Yield of Semiconductor Device (%) | | | 25 | 44 | 57 | 70 | 68 | 65 | 61 |

When the first comparable example is compared with the first to sixth examples in Table 1, it has been found that a semiconductor-layer-stacked wafer having small light emission intensity distribution is obtained and the yield of a semiconductor device is increased by forming at least one group-III nitride crystal layer on the side of a crystal growth surface of a GaN crystal substrate in which a rear surface opposite to the crystal crystal growth surface has a warpage$_{(R)}$ satisfying -35 μm ≤ $w_{(R)}$ ≤ 45 μm.

Further, when the first and sixth examples are compared with the second to fifth examples, it has been found that a semiconductor-layer-stacked wafer having smaller light emission intensity distribution is obtained and the yield of a semiconductor device is further increased by forming at least one group-III nitride crystal layer on the side of a crystal growth surface of a GaN crystal substrate in which a rear surface opposite to the crystal growth surface has a warpage$_{(R)}$ satisfying -35 μm ≤ $w_{(R)}$ ≤ 45 μm, a surface roughness $Ra_{(R)}$ satisfying $Ra_{(R)}$ ≤ 10 μm, and a surface roughness $Ry_{(R)}$ satisfying $Ry_{(R)}$ ≤ 75 μm.

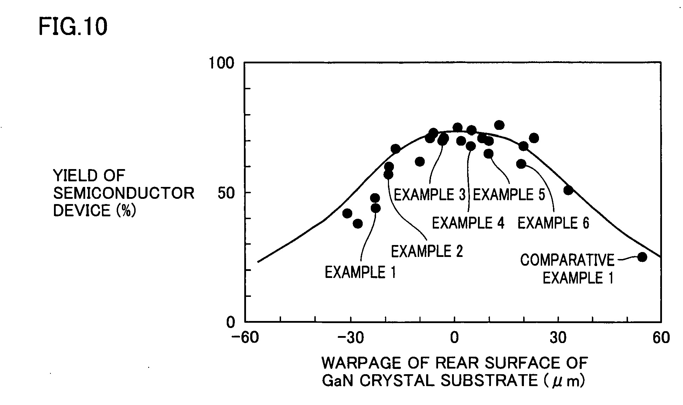

Fig. 10 shows relation between the warpage of the rear surface of the GaN crystal substrate and the yield of the semiconductor device in a plurality of semiconductor devices obtained in the third embodiment. Fig. 10 includes points concerning the first comparative example and the first to sixth examples. As shown in Fig. 10, the yield of the semiconductor device was increased when warpage$_{(R)}$ of the rear surface of the GaN crystal substrate was -35 μm ≤ $w_{(R)}$ ≤ 45 μm. A preferable range of the warpage of the rear surface is larger on a positive (+) side than on a negative (-) side because, as has been already contemplated referring to Figs. 1A and 1B, when the warpage of rear surface 10r is indicated with a positive (+) sign, closed gap portion 9s is formed between rear surface 10r and the surface of susceptor 9 (see Fig. 1A), and when the warpage of rear surface 10r is indicated with a negative (-) sign, open gap portion 9s is formed between rear surface 10r and the surface of susceptor 9 (see Fig. 1B), and thus heat distribution in the substrate when the warpage is indicated with a positive (+) sign is smaller than heat distribution in the substrate when the warpage indicated with a negative (-) sign.

Although the present invention has been described and illustrated in detail, it is clearly understood that the same is by way of illustration and example only and is not to be taken by way of limitation, the scope of the present invention being limited only by the terms of the appended claims.

**Claims**

1. A GaN crystal substrate, said GaN crystal substrate being cut out of a grown GaN crystal (1) and comprising:

a crystal growth surface (10c); and

a rear surface (10r) opposite to said crystal growth surface (10c), said rear surface (10r) having a warpage $w_{(R)}$ satisfying $-35 \mu m \leq w_{(R)} \leq 45 \mu m$ per 5.08 cm length, said rear surface (10r) has an arithmetic mean surface roughness $Ra_{(R)}$ satisfying $1 \mu m \leq Ra_{(R)} \leq 10 \mu m$,

wherein said crystal growth surface (10c) has an arithmetic mean surface roughness Ra(c) satisfying Ra(c) $\leq 10$ nm.

2. The GaN crystal substrate according to claim 1, wherein said rear surface (10r) has a maximum height surface roughness $Ry_{(R)}$ satisfying $Ry_{(R)} \leq 75 \mu m$.

3. The GaN crystal substrate according to claim 1, wherein said crystal growth surface (10c) has a warpage $w_{(C)}$ satisfying $-50 \mu m \leq w_{(C)} \leq 50 \mu m$ per 5.08 cm length, an arithmetic mean surface roughness $Ra_{(C)}$ satisfying $Ra_{(C)} \leq 10$ nm, and a maximum height surface roughness $Ry_{(C)}$ satisfying $Ry_{(C)} \leq 60$ nm.

4. A method of manufacturing a GaN crystal substrate (10) having:

a crystal growth surface (10c); and

a rear surface (10r) opposite to said crystal growth surface (10c), said rear surface (10r) having a warpage $w_{(R)}$ satisfying $-35 \mu m \leq w_{(R)} \leq 45 \mu m$ per 5.08 cm length, said rear surface (10r) has an arithmetic mean surface roughness $Ra_{(R)}$ satisfying $1 \mu m \leq Ra_{(R)} \leq 10 \mu m$, wherein said crystal growth surface (10c) has an arithmetic mean surface roughness Ra(c) satisfying Ra(c) $\leq 10$ nm.

comprising the steps of:

cutting said GaN crystal substrate (10) out of a grown GaN crystal (1); and
processing said rear surface (10r) of said GaN crystal substrate (10),

wherein said step of processing said rear surface (10r) of said GaN crystal substrate (10) includes the steps of grinding said rear surface (10r) and etching said rear surface (10r).

5. A method of manufacturing a semiconductor device, comprising the step of preparing as a substrate a GaN crystal substrate (10) having a crystal growth surface (10c) and a rear surface (10r) opposite to said crystal growth surface (10c), said rear surface (10r) having a warpage $w_{(R)}$ satisfying $-35 \mu m \leq w_{(R)} \leq 45 \mu m$ per 5.08 cm length, said rear surface (10r) has an arithmetic mean surface roughness $Ra_{(R)}$ satisfying $1 \mu m \leq Ra_{(R)} \leq 10 \mu m$, wherein said crystal growth surface (10c) has an arithmetic mean surface roughness Ra(c) satisfying Ra(c) $\leq 10$ nm, and growing at least one group-III nitride crystal layer (20) on a side of said crystal growth surface (10c) of said GaN crystal substrate (10).

**Patentansprüche**

1. GaN-Kristallsubstrat, wobei das GaN-Kristallsubstrat aus einem gezüchteten GaN-Kristall (1) ausgeschnitten wird und umfasst:

eine Kristallwachstumsoberfläche (10c); und
eine hintere Oberfläche (10r) gegenüber der Kristallwachstumsoberfläche (10c), wobei die hintere Oberfläche (10r) einen Verzug $w_{(R)}$ aufweist, der $-35 \mu m \leq w_{(R)} \leq 45 \mu m$ pro 5,08 cm Länge erfüllt, die hintere Oberfläche (10r) eine arithmetische mittlere Oberflächenrauigkeit $Ra_{(R)}$ aufweist, die $1 \mu m \leq Ra_{(R)} \leq 10 \mu m$ erfüllt,

wobei die Kristallwachstumsoberfläche (10c) eine arithmetische mittlere Oberflächenrauigkeit Ra(c) aufweist, die Ra(c) $\leq 10$ nm erfüllt.

2. GaN-Kristallsubstrat nach Anspruch 1, wobei die hintere Oberfläche (10r) eine Oberflächenrauigkeit mit maximaler Höhe $Ry_{(R)}$ aufweist, die $Ry_{(R)} \leq 75 \mu m$ erfüllt.

3. GaN-Kristallsubstrat nach Anspruch 1, wobei die Kristallwachstumsoberfläche (10c) einen Verzug $w_{(C)}$ aufweist, der $-50 \mu m \leq w_{(C)} \leq 50 \mu m$ pro 5,08 cm Länge erfüllt, eine arithmetische mittlere Oberflächenrauigkeit $Ra_{(C)}$, die $Ra_{(C)} \leq 10$ nm erfüllt, und eine Oberflächenrauigkeit mit maximaler Höhe $Ry_{(C)}$, die $Ry_{(C)} \leq 60$ nm erfüllt.

**4.** Verfahren zur Herstellung eines GaN-Kristall Substrats (10), das Folgendes aufweist:

eine Kristallwachstumsoberfläche (10c); und
eine hintere Oberfläche (10r) gegenüber der Kristallwachstumsoberfläche (10c), wobei die hintere Oberfläche (10r) einen Verzug $w_{(R)}$ aufweist, der -35 $\mu$m $\leq w_{(R)} \leq$ 45 $\mu$m pro 5,08 cm Länge erfüllt, die hintere Oberfläche (10r) eine arithmetische mittlere Oberflächenrauigkeit $Ra_{(R)}$ aufweist, die 1 $\mu$m $\leq Ra_{(R)} \leq$ 10 $\mu$m erfüllt, wobei die Kristallwachstumsoberfläche (10c) eine arithmetische mittlere Oberflächenrauigkeit Ra(c) aufweist, die Ra(c) $\leq$ 10 nm erfüllt,

umfassend folgende Schritte:

Ausschneiden des GaN-Kristallsubstrats aus einem gezüchteten GaN-Kristall (1); und
Bearbeiten der hinteren Oberfläche (10r) des GaN-Kristall Substrats (10), wobei der Schritt zum Bearbeiten der hinteren Oberfläche (10r) des GaN-Kristall Substrats (10) die Schritte zum Schleifen der hinteren Oberfläche (10r) und zum Ätzen der hinteren Oberfläche (10r) beinhaltet.

**5.** Verfahren zum Herstellen einer Halbleitervorrichtung, umfassend den Schritt zum Vorbereiten, als Substrat, eines GaN-Kristall Substrats (10) mit einer Kristallwachstumsoberfläche (10c) und einer hinteren Oberfläche (10r) gegenüber der Kristallwachstumsoberfläche (10c), wobei die hintere Oberfläche (10r) einen Verzug $w_{(R)}$ aufweist, der -35 $\mu$m $\leq w_{(R)} \leq$ 45 $\mu$m pro 5,08 cm Länge aufweist, die hintere Oberfläche (10r) eine arithmetische mittlere Oberflächenrauigkeit $Ra_{(R)}$ aufweist, die 1 $\mu$m $\leq Ra_{(R)} \leq$ 10 $\mu$m erfüllt, wobei die Kristallwachstumsoberfläche (10c) eine arithmetische mittlere Oberflächenrauigkeit Ra(c) aufweist, die Ra(c) $\leq$ 10 nm erfüllt, und das Wachstum mindestens eine Gruppe-III-Nitridkristallschicht (20) auf einer Seite der Kristallwachstumsoberfläche (10c) des GaN-Kristallsubstrats (10) beinhaltet.

## Revendications

**1.** Substrat cristallin de GaN, ledit substrat cristallin de GaN étant découpé dans un cristal de GaN (1) obtenu par croissance cristalline et comprenant :

une surface de croissance cristalline (10c) ; et
une surface arrière (10r) opposée à ladite surface de croissance cristalline (10c), ladite surface arrière (10r) présentant un gauchissement $w_{(R)}$ satisfaisant à - 35 $\mu$m $\leq w_{(R)} \leq$ 45 $\mu$m pour une longueur de 5,08 cm, ladite surface arrière (10r) ayant une rugosité de surface moyenne arithmétique $Ra_{(R)}$ satisfaisant à 1 $\mu$m $\leq Ra_{(R)} \leq$ 10 $\mu$m, ladite surface de croissance cristalline (10c) ayant une rugosité de surface moyenne arithmétique Ra(c) satisfaisant à Ra(c) $\leq$ 10 nm.

**2.** Substrat cristallin de GaN selon la revendication 1, ladite surface arrière (10r) ayant une hauteur maximale de rugosité de surface $Ry_{(R)}$ satisfaisant à $Ry_{(R)} \leq$ 75 $\mu$m.

**3.** Substrat cristallin de GaN selon la revendication 1, ladite surface de croissance cristalline (10c) présentant un gauchissement $w_{(C)}$ satisfaisant à 50 $\mu$m $\leq w_{(C)} \leq$ 50 $\mu$m pour une longueur de 5,08 cm, une rugosité de surface moyenne arithmétique $Ra_{(C)}$ satisfaisant à $Ra_{(C)} \leq$ 10 nm et une hauteur maximale de rugosité de surface $Ry_{(C)}$ satisfaisant à $Ry_{(C)} \leq$ 60 nm.

**4.** Procédé de fabrication d'un substrat cristallin de GaN (10) comprenant :

une surface de croissance cristalline (10c) ; et
une surface arrière (10r) opposée à ladite surface de croissance cristalline (10c), ladite surface arrière (10r) présentant un gauchissement $w_{(R)}$ satisfaisant à - 35 $\mu$m $\leq w_{(R)} \leq$ 45 $\mu$m pour une longueur de 5,08 cm, ladite surface arrière (10r) ayant une rugosité de surface moyenne arithmétique $Ra_{(R)}$ satisfaisant à 1 $\mu$m $\leq Ra_{(R)} \leq$ 10 $\mu$m, ladite surface de croissance cristalline (10c) ayant une rugosité de surface moyenne arithmétique Ra(c) satisfaisant à Ra(c) $\leq$ 10 nm ; comportant les étapes consistant à :

découper ledit substrat cristallin de GaN (10) dans un cristal de GaN (1) obtenu par croissance cristalline ; et transformer ladite surface arrière (10r) dudit substrat cristallin de GaN (10),
ladite étape de transformation de ladite surface arrière (10r) dudit substrat cristallin de GaN (10) comportant les étapes de meulage de ladite surface arrière (10r) et
d'attaque de ladite surface arrière (10r).

5. Procédé de fabrication d'un dispositif semi-conducteur, comportant l'étape de préparation, en tant que substrat, d'un substrat cristallin de GaN (10) comprenant une surface de croissance cristalline (10c) et une surface arrière (10r) opposée à ladite surface de croissance cristalline (10c), ladite surface arrière (10r) présentant un gauchissement $w_{(R)}$ satisfaisant à -35 $\mu$m $\leq w_{(R)} \leq$ 45 $\mu$m pour une longueur de 5,08 cm, ladite surface arrière (10r) ayant une rugosité de surface moyenne arithmétique $Ra_{(R)}$ satisfaisant à 1 $\mu$m $\leq Ra_{(R)} \leq$ 10 $\mu$m, ladite surface de croissance cristalline (10c) ayant une rugosité de surface moyenne arithmétique $Ra(c)$ satisfaisant à $Ra(c) \leq$ 10 nm, et de croissance d'au moins une couche (20) de cristal de nitrure du groupe III sur un côté de ladite surface de croissance cristalline (10c) dudit substrat cristallin de GaN (10).

FIG.1A

FIG.1B

# FIG.2

S1 | SUBSTRATE DETECTION STEP

S2 | NOISE REMOVAL STEP

S3 | OUTER PERIPHERAL PORTION REMOVAL STEP

S2 | NOISE REMOVAL STEP

C1 OPTIMIZATION CYCLE

S4 | SMOOTHING STEP

S2 | NOISE REMOVAL STEP

S5 | BEST FIT PLANE CALCULATION STEP

S6 | WARPAGE CALCULATION STEP

FIG.3

FIG.4

FIG.5

## FIG.6A

| | | |
|---|---|---|
| $f(a-1,b+1)$ | $f(a,b+1)$ | $f(a+1,b+1)$ |
| $f(a-1,b)$ | $f(a,b)$ | $f(a+1,b)$ |
| $f(a-1,b-1)$ | $f(a,b-1)$ | $f(a+1,b-1)$ |

## FIG.6B

| | | |
|---|---|---|
| 0.96 | 0.98 | 0.96 |
| 0.98 | 1.00 | 0.98 |
| 0.96 | 0.98 | 0.96 |

$\sigma = 5$
BEFORE
NORMALIZATION

## FIG.6C

| | | |
|---|---|---|
| 0.110 | 0.112 | 0.110 |
| 0.112 | 0.114 | 0.112 |
| 0.110 | 0.112 | 0.110 |

$\sigma = 5$
AFTER
NORMALIZATION

## FIG.7A

## FIG.7B

## FIG.8

## FIG.9

FIG.10

YIELD OF SEMICONDUCTOR DEVICE (%)

WARPAGE OF REAR SURFACE OF GaN CRYSTAL SUBSTRATE ($\mu$m)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000012900 A
- WO 0168955 A1
- EP 1246233 A2
- US 20030045103 A1
- EP 0966047 A2
- EP 1475826 A2